# EUROPEAN PATENT SPECIFICATION

(11) **EP 2 812 888 B1**
(45) Date of publication and mention of the grant of the patent: **14.11.2018**
(21) Application number: 13709967.7
(22) Date of filing: 25.01.2013
(51) Int. Cl.: G08B 13/12, G08B 13/14, G08B 13/22

(54) **METALLIC CONDUCTOR DISTURBANCE DETECTION DEVICE AND METHOD**
METALLLEITERSTÖRUNGSERKENNUNGSVORRICHTUNG UND VERFAHREN
DISPOSITIF ET PROCÉDÉ DE DÉTECTION DE PERTURBATIONS DANS UN CONDUCTEUR MÉTALLIQUE

(30) Priority: 08.02.2012 GB 201202202; 14.09.2012 GB 201216492
(43) Date of publication of application: 17.12.2014
(73) Proprietor: Cresatech Limited, Aylesbury, Buckinghamshire HP19 8HL (GB)
(72) Inventor: JARVIS, Simon James, Broughton Beck Cumbria LA127PH (GB); MUMFORD, Paul, Amersham Buckinghamshire HP7 9DQ (GB); MERCHANT, Roger, St Paul, Nebraska 68873 (US)
(74) Representative: Hocking, Adrian Niall
(86) International application number: PCT/GB2013/050165
(87) International publication number: WO 2013/117905

(56) References cited:
- GB-A- 2 317 707
- US-A- 3 848 243
- US-A1- 2010 085 189
- US-A1- 2010 328 072

## Description

The present invention relates to a metallic conductor disturbance detection device, and to a method of detecting disturbance in or in the vicinity of a metallic conductor.

Due to their rapidly increasing value, incidents of tampering and/or removal of metal conductors, such as copper or aluminium, in metallic infrastructures such as telecommunications sites and transport sites have risen steadily over recent years, and are thus becoming a problem worldwide.

Additionally, being able to monitor for natural degradation in metallic conductors, due to corrosion or accidentally inflicted damage, would be beneficial.

In an attempt to combat the widespread theft of such metallic conductors, a number of solutions have been proposed. These solutions can generally be divided into three categories: prevention of thieves or unauthorised persons getting onto or into the site; detection of thieves or unauthorised persons whilst on the site; and catching the thieves or 'handlers' receiving the illegally removed materials after the event

Prevention typically includes security fencing, including electric fencing, but has not proved effective in preventing entry of determined thieves.

Detection primarily utilises established 'traditional' security technology for detecting thieves when on site. The technology used is predominantly Monitored CCTV, Movement and Sound Sensors. Monitored site CCTV can provide notice of thieves on site, but does not confirm what has been removed. Furthermore, it is also still prohibitively expensive for most sites. Devices such as movement and sound sensors are prone to false alarms in such site environments, due for example to animals passing through the site, which adds to operational costs and inconvenience.

The third approach is to ensure capture of the thieves or handlers after the event. The most established approaches and technologies in this area are: SmartWater RTM which provides invisible traceability of the material stolen and has proved very effective in addressing the resale of the stolen materials; printing the owner identification on the sheathing/casing, which is a deterrent but as a common practice can be burnt off; and 'Land Mines' containing visible and/or invisible dye and which detonates upon being disturbed when thieves are in unauthorized areas.

This latter arrangement is a recent development which again will aid in the identification of thieves.

The present invention falls into the category of detection, thereby aiming to prevent or limit removal of and/or damage to the metallic conductors in the first place, and thereby improving safety and decreasing operational downtime. A similar method for detecting the unauthorized removal or tampering with of bulky movable objects is disclosed in US3848243.

According to a first aspect of the invention, there is provided a method of detecting disturbance in a metallic conductor, the method comprising the steps of providing an inductance sensing circuit including a transformer having a first primary coil and a second primary coil on a metallic conductor side, and a secondary coil on an alarm circuit side, the first primary coil being supplied on a first circuit with an internally generated circuit oscillation by an oscillating power source or oscillator, the second primary coil being mechanically and electrically connected to the metallic conductor having a monitorable inductance on a second circuit which is independent of the first circuit such that the oscillating power source or oscillator is not directly connected to the metallic conductor, tuning the inductance sensing circuit based on an electromagnetic field impressed upon the metallic conductor and the internally generated circuit oscillation into the first primary coil, wherein the inductance sensing circuit is tuned as a function of the monitorable inductance on the second circuit, and outputting an alert signal when a tuned output signal from the tuned inductance sensing circuit becomes detuned due to a change in inductance of the metallic conductor by disturbance of at least a portion of the metallic conductor.

Preferable and/or optional features of the first aspect of the invention are set forth in claims 2 to 7, inclusive.

According to a second aspect of the invention, there is provided a metallic conductor disturbance detection device for a method in accordance with the first aspect of the invention.

According to an aspect not in accordance with the present invention, there is provided a metallic conductor disturbance detection device for detecting disturbance in a metallic conductor, the device comprising an inductance sensing circuit including a transformer having first and second primary windings and a secondary winding, and a tuneable oscillator in electrical communication with the first primary winding of the transformer, the second primary winding being mechanically and electrically communicable with a metallic infrastructure, and the secondary winding being able to output a tuned output signal based on a first condition of the metallic infrastructure, and a detuned output signal based on a second condition of the metallic infrastructure caused by addition to or removal of at least a portion of the metallic conductor.

According to an aspect not in accordance with the present invention, there is provided a metallic conductor disturbance detection device in mechanical and electrical communication with a metallic infrastructure, the device comprising an inductance sensing circuit including a transformer having first and second primary windings and a secondary winding, and a tuneable oscillator in electrical communication with the first primary winding of the transformer, the second primary winding in mechanical and electrical communication with the metallic infrastructure, and the secondary winding ouputting a tuned output signal based on an untampered condition of the metallic infrastructure and a detuned output signal based on a tampered condition of the metallic infrastructure.

According to an aspect not in accordance with the present invention, there is provided a method of detecting disturbance in a metallic conductor, the method comprising the steps of providing an inductance sensing circuit electrically connected to a metallic conductor having a monitorable inductance, tuning the inductance sensing circuit based on an electromagnetic field impressed upon the metallic conductor and an internally generated circuit oscillation, and outputting an alert signal when a tuned output signal from the tuned inductance sensing circuit becomes detuned due to a change in inductance of the metallic conductor by addition to or removal of at least a portion of the metallic conductor.

According to an aspect not in accordance with the present invention, there is provided a method of detecting disturbance in a metallic conductor, the method comprising the steps of providing an inductance sensing circuit in electrical and mechanical communication with a metallic conductor having a monitorable inductance, tuning the inductance sensing circuit by utilising an oscillator which impresses an electromagnetic field on the metallic conductor, and outputting an alert signal when a tuned output signal from the tuned inductance sensing circuit becomes detuned due to a change in inductance of the metallic conductor by addition to or removal of at least a portion of the metallic conductor.

The invention will now be more particularly described, by way of example only, with reference to the accompanying drawings, in which:
Figure 1a shows a circuit diagram of a first embodiment of a metallic conductor disturbance detection device, in accordance with the second aspect of the invention and shown with circuit modules identified for clarity;
Figure 1b shows the circuit diagram of Figure 1a with the electrical components referenced for clarity;
Figure 2 is a circuit diagram showing an electrical representation of a metallic conductor to be monitored by the metallic conductor disturbance detection device of Figures 1a and 1b;
Figure 3 shows a block circuit diagram of a first example of a connection between the metallic conductor disturbance detection device and a metallic infrastructure comprising at least one metallic conductor, in accordance with the first aspect of the invention;
Figure 4 shows a block circuit diagram of a second simplified example of a connection between the metallic conductor disturbance detection device and a metallic infrastructure comprising at least one metallic conductor, in accordance with the first aspect of the invention;
Figure 5 shows a block circuit diagram of a third example of a connection between the metallic conductor disturbance detection device and a metallic infrastructure comprising at least one metallic conductor, wherein only a single connection is required between the device and the conductor, again in accordance with the first aspect of the invention;
Figure 6 shows a second embodiment of a metallic conductor disturbance detection device, in accordance with the second aspect of the invention;
Figure 7 shows a third embodiment of a metallic conductor disturbance detection device, in accordance with the second aspect of the invention; and
Figure 8 shows a fourth embodiment of a metallic conductor disturbance detection device, in accordance with the second to fifth aspects of the invention.

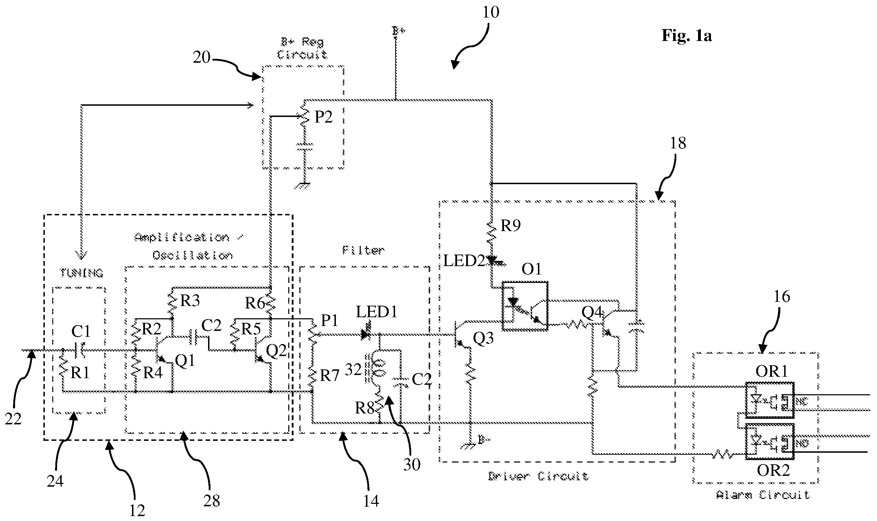

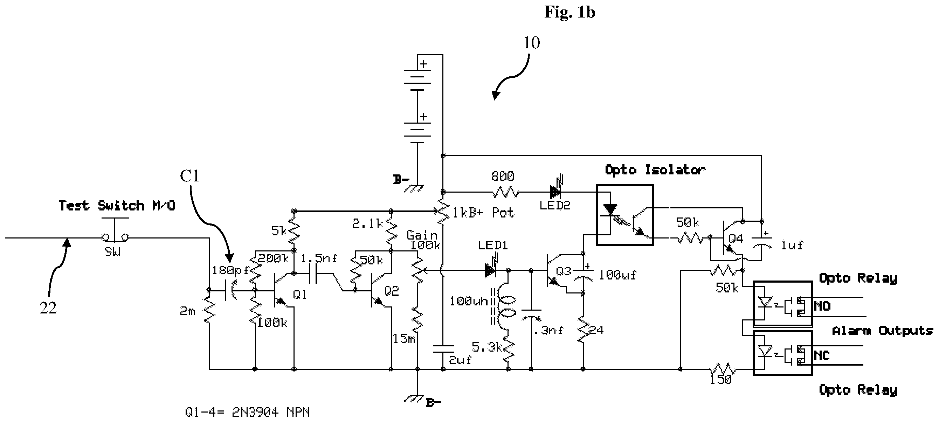

Referring firstly to Figures 1a and 1b of the invention, a first embodiment of a metallic conductor disturbance detection device 10 is shown which comprises an inductance sensing circuit 12, a filter circuit 14 connected to an output of the inductance sensing circuit 12, and an alarm circuit 16 for outputting an alarm signal based on an output of the filter circuit 14. The device 10 preferably further comprises a driver circuit 18 for driving the inductance sensing circuit 12, filter circuit 14 and/or the alarm circuit 16, and additionally or alternatively a voltage regulation circuit 20.

A sense wire 22 passes into the sensing circuit 12 via a momentary push button test switch SW located on a left side of the sensing circuit 12.

From the test switch SW, a connection is made to a tuneable capacitor C1 forming part of a tuning circuit 24 of the sensing circuit 12. For the present embodiment, the tuneable capacitor C1 has a value range between 9 and 180 Pico Farads, and is utilised to regulate or couple the device 10 to the metallic conductor forming part of the metallic infrastructure 26 to be monitored.

If added stability is deemed desirable or necessary for the proper operation of the circuit, a 2 MΩ resistor R1 between the input of the tuneable capacitor C1 and a B- of the device 10 may be employed to shunt a portion of the impressed signal to ground, thereby limiting the initial gain the sensing circuit will have and preventing it from becoming saturated.

The tuneable capacitor C1 is connected to a base of transistor Q1, in this case being an NPN Small signal transistor, and which forms a first stage of an amplification / oscillation circuit 28 of the sensing circuit 12.

A biasing resistor R2 of approximately 200 KΩ is connected from a collector junction of transistor Q1 to a base junction to provide the necessary biasing of the transistor Q1.

A 5KΩ resistor R3 from B+ to the collector of transistor Q1 provides for regulation of the voltage at transistor Q1.

It may also be desirable, depending upon the application, to employ a shunt resistor R4 of approximately 100 KΩ from the base connection of transistor Q1 to ground to further stabilize the device 10 if it is employed in an application where the risk of over saturation of the base of the first said transistor Q1 may become an issue.

In use, an incoming signal of a given frequency and amplitude is mixed with a local oscillation produced by the amplification / oscillation circuit 28 comprising transistor Q1. The signal is then fed via a fixed ceramic capacitor C2 of approximately 1.5 Nano Farads into a base junction of a second transistor Q2, wherein the combined signal is amplified still further in the same manner and configuration as transistor Q1.

A 50 KΩ resistor R5 providing a bias voltage from the collector to base is employed, and a 2.1 KΩ resistor R6 between B+ and the collector junction is preferably utilised on transistor Q2.

The input signal at this point has been sufficiently amplified by the amplification / oscillation circuit 28 and is directly fed into a 100 KΩ pot PI that is employed as an output gain control. The 100 KΩ pot PI is connected to B- via a very high value resistor R7, which in the present case has a value of 15 MΩ, but the value of the resistance can be as small as 2 MΩ and still give good results.

A wiper of the 100 KΩ pot PI is then fed to an anode of a first LED, referenced as LED 1, to provide one form of visual indication of the operational status of the device 10. A cathode connection of LED 1 is connected to a tuneable band pass filter 30 of the filter circuit 14 which is in parallel with an output of said LED 1 and B-.

The filter circuit 14 communicating with the output of the amplification / oscillation circuit 28 in this case comprises a 100 µH coil 32 which is in series with a 5.3 KΩ resistor R8 to B-. A variable capacitor C2 of 0.3 Nano Farad is in parallel with the coil 32 and resistor R8. The band pass filter 30 of the filter circuit 14 can thus be tuned by varying the capacity with respect to the coil inductance if it is deemed desirable to change the characteristics of the band pass filter 30 for a specific application.

A further cathode is also connected to a base junction of a driver transistor Q3 forming part of a driver circuit 18 of the device 10. The driver circuit 18 is utilised to regulate an operational status of an opto isolator O1 outputting to the alarm circuit 16.

In a normal operating condition, the driver transistor Q3 is in a semi-ON condition ideally about halfway between full ON and full OFF conditions thereby providing a null condition. To achieve the desired adjustment, a second LED, referenced as LED 2, is provided as a visual indicator for tuning purposes.

By adjustment of the tuneable capacitor C1 of the tuning circuit 24, the 100 KΩ gain pot PI of the filter circuit 14, and B+ via the voltage regulation circuit 20, correct tuning of the device 10 is achievable and the device 10 can be rendered to a sensitive state.

The positive voltage B+ feeding the device 10 is preferably adjustable by a 1 KΩ pot P2 in series with the B+ voltage supply and the amplification / oscillation circuit 28 of the device 10. In practice, this pot P2 is typically adjusted to some ideal or optimum value and will require little or no further adjustment in the field thereafter, wherein the primary means of adjusting the device 10 to a tuned state will be via the adjustments of the variable capacitor C1 of the tuning circuit 24 and the 100 KΩ output gain pot P1 of the filter circuit 14.

To prevent damage to LED 2, an 800 Ω resistor R9 is provided in series with an anode of LED 2 to limit potentially damaging current. At this point, the opto isolator O1 is biased to an ON state wherein a bias voltage passes through an additional transistor Q4 to drive opto relays OR1, OR2 provided in the alarm circuit 16.

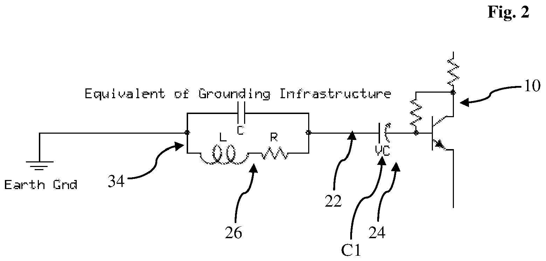

Referring to Figure 2, an electrical representation of a metallic conductor 34 forming part of the metallic infrastructure 26, such as a telecommunications mast or site, a utility site, for example, an electricity substation, and/or a transport site, for example, a railway signalling site, and how the tuning circuit 24 of the sensing circuit 12 is connected thereto will be described.

In this case the metallic conductor 34 is earth grounded such as would be found in a grounding grid. The monitored metallic conductor 34, for example, being copper and typically of a certain length, possess a specific natural inductance as well as natural capacity if the conductor 34 is either positioned slightly above earth or within the same. As the metallic conductor 34 forms a layer of oxidization owing to contact with air and/or soil, a slight capacity is formed by the oxide layer.

The metallic conductor 34 also has a natural resistance depending upon the length of the said conductor 34. The resistance can be very low or may exceed 1Ω or more if it's of a great length. It then may be said that owing to the presence of Inductance, Capacity, and Resistance, referred hereinafter as 'LC&R', the structure will tend to form a tuned circuit owing to the presence of LC&R.

Present within the earth is a plethora of stray currents, both natural and manmade, as well as the presence of low and high frequency alternating currents that can reach into the low radio frequency or RF spectrum. These currents and voltages are induced in the metallic infrastructure 26 owing to its communication with the earth. It is known that such voltages and currents can be read from the metallic conductor 34 either by a voltmeter or an oscilloscope, and will result in both a frequency and amplitude reading. These currents and voltages form part of the means by which changes can be monitored if the metallic conductor 34 of the infrastructure 26 is disturbed in some manner.

The complete circuit of the device 10 also generates an oscillation that can be measured on the ground infrastructure 26, and in this invention is combined with the signals already present in or on the metallic conductor 34 to be monitored in order to detect any changes taking place.

When the metallic conductor 34 is disturbed, such as by removal or damage to a portion thereof, a change of voltages and amplitude of the impressed frequencies is received by the device 10 resulting in an alarm condition being generated. It is also understood that changes to the voltages and amplitudes of the impressed frequencies, or in other words the conductive characteristics, of the monitored metallic conductor 34 can also result due to natural corrosion of and/or a body coming within close proximity to the metallic conductor 34. In this case, an alarm condition also occurs.

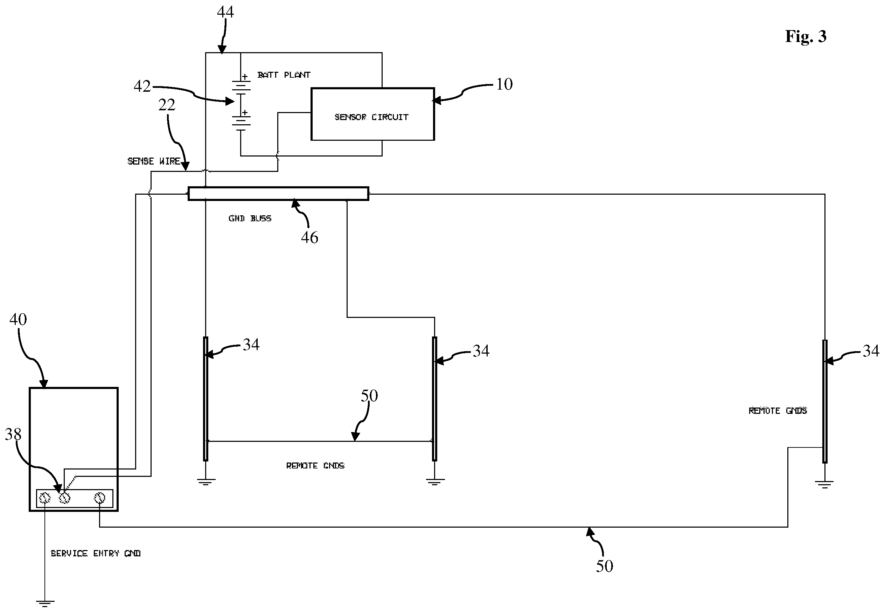

Figure 3 shows a first example of the metallic conductor disturbance detection device 10 arranged to monitor a grounded metallic conductor 34 of a monitored infrastructure 26. An input of the tuning circuit 24 of the device 10 is mechanically connected via the electrical sense wire, lead or cable 22 to one portion of a grounding grid, which in this example is illustrated as a connection to a ground terminal 38 of a power service entry box 40 serving as a primary single grounding point for the site.

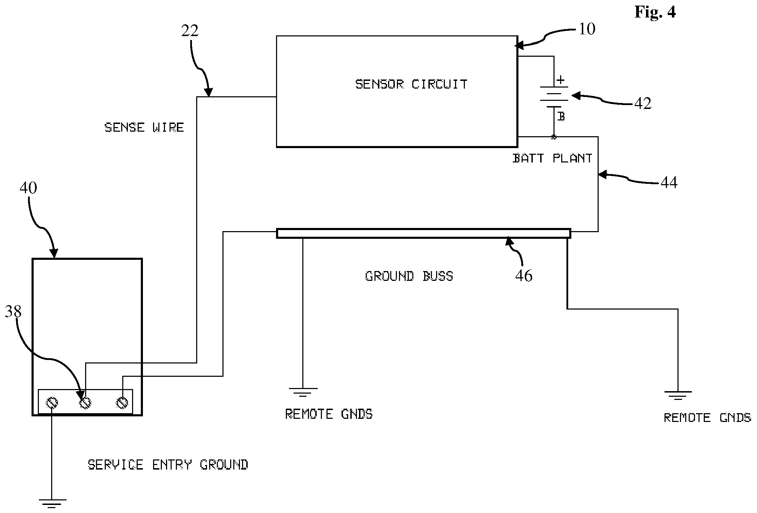

From a power supply 42, in this case being for example a battery plant, supplying power to the device 10 and possibly other site electronics, a further wire 44 is often taken to ground the power supply 42. This can be a positive ground as shown in Figure 3, or a negative ground as shown in Figure 4.

In some applications of the present invention, a second connection to the battery plant or other power supply 42 and to the device 10 is also employed as a second sense path for monitoring changes within the or another metallic conductor 34 of the monitored infrastructure 26.

A buss bar or master ground buss 46 forms part of the monitored infrastructure 26 and is in electrical communication with the metallic conductor or conductors 34. The various structures are at ground potential and are interconnected and grounded to the master buss 46. Typically, these structures are connected or bonded together and to the ground buss 46 via copper cable of reasonably large diameter both buried within the earth as well as above the earth. In some applications, a further ground grid remote from the service entry grid 40 is connected or bonded to both the master ground buss 46 and the service entry ground 38 thereby forming a ground loop. Typically, in such networks one or more ground loops 50 will exist within the infrastructure 26 as indicated in the drawing of Figure 3. When any portion of the infrastructure 26 is tampered with or removed, there will be a corresponding change typically in amplitude and/or inductance of the impressed signal within the infrastructure 26 and as before mentioned, this change triggers an alarm condition in the device 10.

Referring to Figure 4, a second example of the connection of the metallic conductor disturbance detection device 10 to a monitored infrastructure 26 having one or more metallic conductors 34 is shown. The arrangement of Figure 4 is a simplified version of Figure 3, wherein the further ground grids as described previously are omitted. The input of the tuning circuit 24 is mechanically connected via an electrical sense cable, wire or lead 22 to a power distribution board or other service entry unit 40. The power supply 42 is preferably grounded to the buss bar or master ground buss 46, as before. Operation is therefore in much the same manner as the first example above.

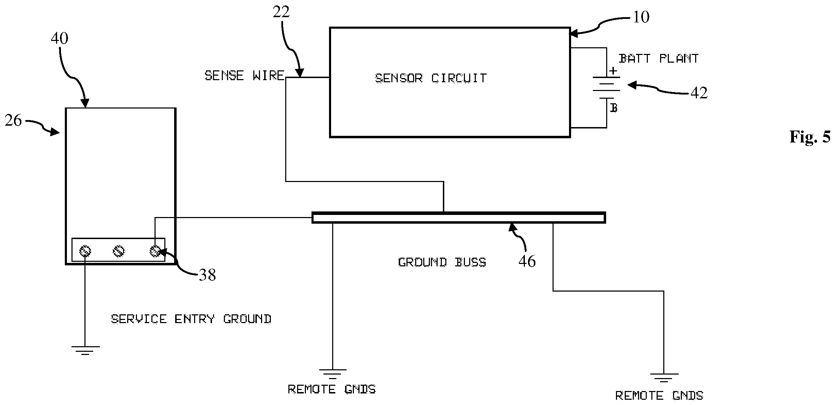

Figure 5 illustrates a third example of the connection of the metallic conductor disturbance detection device 10 to a monitored infrastructure 26 having one or more metallic conductors 34. The interconnection in this example is different to that of the preceding two examples. In this case, the battery plant or power supply 42 may be independent or 'floating' with respect to the metallic infrastructure 26. As such, only a single connection via the tuning circuit 24 to the infrastructure 26 to be monitored is required. When the device 10 has therefore been properly adjusted, it is capable of detecting changes within said infrastructure 26 with only a single connection being made to the device 10.

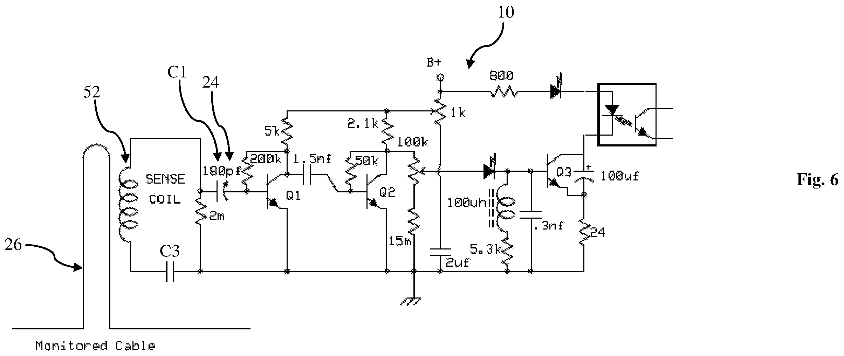

Referring now to Figure 6, a second embodiment of the metallic conductor disturbance detection device 10 will now be described. Like references refer to parts which are similar or identical to those of the first embodiment, and therefore further detailed description will be omitted. A portion of the driver circuit 18 from the opto isolator 01 and the alarm circuit 16 are omitted for ease of reference, as these match or substantially match those of Figures 1a and 1b. The device 10 comprises the sensing circuit 12, filter circuit 14, voltage regulation circuit 20, driver circuit 18 and alarm circuit 16, as before. The sensing circuit 12 includes the tuning circuit 24 and a modified amplification / oscillation circuit 28. The primary difference resides in the modified sensing circuit 12.

In this embodiment, the sensing circuit 12 has been adapted to include a sensing pick-up coil 52 at the input to the tuning circuit 24. The pick-up coil 52 is connected between the input of the tuneable capacitor C1 and B- via a second capacitor C3 of small value, in the order of Nano or Pico Farads. This wireless connector permits the device 10 to be utilised in environments where a direct mechanical connection to the infrastructure 26 to be monitored has been deemed either hazardous or otherwise undesirable, for example, being AC or DC powered, or of another signal type. When such limitations are encountered, it has been found that employing the pick-up coil 52 in the configuration illustrated in Figure 6 gives very good results.

It may also be advantageous to include electrical shielding to some degree in order to prevent or limit the circuits of the device 10 from becoming saturated with spurious RF interference.

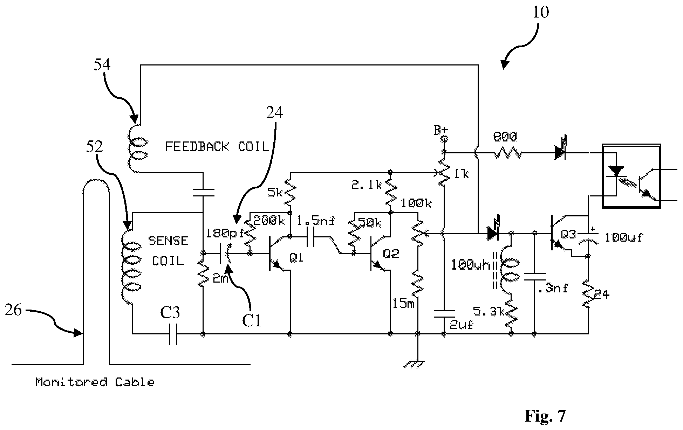

Referring now to Figure 7, a third embodiment of the metallic conductor disturbance detection device 10 will now be described. Again, like references refer to parts which are similar or identical to those of the first and second embodiments, and therefore further detailed description will be omitted, and as with Figure 6 a portion of the driver circuit 18 from the opto isolator O1 and the alarm circuit 16 are omitted for clarity, as these match or substantially match those of Figures 1a and 1b.

The device 10 of the second embodiment comprises the sensing circuit 12, filter circuit 14, voltage regulation circuit 20, driver circuit 18 and alarm circuit 16, as before. The sensing circuit 12 includes the tuning circuit 24 and a further modified amplification / oscillation circuit 28. The primary difference resides again in the further modified sensing circuit 12.

The further modified sensing circuit 12 includes the sensing pick-up coil 52 at the input to the tuning circuit 24 and a tickler coil 54. A portion of the output signal from the filter circuit 14 is routed back to the input of the tuning circuit 24 and caused to act upon the pick-up coil 52 inductively in a manner similar to a regenerative feedback circuit. The sensing circuit 12 is thus rendered extremely sensitive to external RF signals.

It should be understood that combinations of the above examples and embodiments may be utilised.

In use, the preferred embodiments of the metallic conductor disturbance detection device 10 provide a single connection to the tuning circuit 24 from the external metallic infrastructure 26, and the tuning circuit 24 utilises a variable capacitor C1 to aid tuning.

The metallic conductor 34 of the infrastructure 26 to be monitored possesses qualities of RC&L and may thus be treated as a tuned or tuneable circuit.

While in such cases the metallic conductor 34 may be in some manner grounded, it will none the less as mentioned above be influenced by ambient RF and other forms of electromagnetic fields present in both the atmosphere and within the earth.

Electrical oscillation is generated internally within the device 10 through feedback from the output stage of the filter circuit 14 back to the input stage via the B+ rail or trace line.

By adjusting the filter circuit 14 and voltage regulation circuit 20 via respective potentiometers, for example, and the tuning circuit 24 by the variable capacitor, for example, the frequency of oscillations can be adjusted to the point where a resonant condition is created. The device 10 is first energised and adjusted to a condition wherein the device 10 is close to an ideal resonant condition. As the variable capacitor C1 of the tuning circuit 24 is varied, the amplitude from the external circuit increases. At a certain point this amplitude will begin to effect the natural oscillation of the sensing circuit 12. This is due to the degree of saturation of the base of transistor Q1 by the increase in amplitude of the impressed signal reaching transistor Q1 via the variable RC&L infrastructure 26. At some point, this saturation will affect the natural frequency of the sensing circuit 12, whereby changing the frequency of the sensing circuit 12 causes the sensing to become extremely sensitive and may be considered in a near state of ideal resonance. If too great an amount of amplitude from the external infrastructure 26 is fed into the base of transistor Q1, the base becomes overly saturated and will send the sensing circuit 12 into full saturation wherein changes within the external infrastructure 26 being measured can no longer be detected. Therefore, it is important that an ideal setting of B+ beneficially settable by the voltage regulation circuit 20 and the amount of coupling between the amplification / oscillation circuit 28 and the external infrastructure 26 be maintained at an optimal value to ensure an ideal sensitivity be maintained at all times.

The tuneable band pass filter 30 is in communication with an output of the amplification / oscillation circuit 28, and is set to allow frequencies of only a certain bandwidth to pass, while attenuating undesirable frequencies.

When the device 10 is connected to the metallic infrastructure 26 to be monitored, the device 10 must be tuned in such a manner that both the electromagnetic fields impressed on the metallic infrastructure 26 from external sources and the internally generated oscillation created by the circuits of the device 10 combine within the device 10 to produce an output frequency that will readily pass through the band pass filter 30.

Both frequency and amplitude are important for the proper operation of the circuit of the present invention.

Amplitude is primarily controlled by the adjustment of the variable capacitor C1 of the tuning circuit 24 at the input of the device 10. The variable capacitor C1 regulates the amount of signal reaching the amplification / oscillation circuit 28 from the metallic infrastructure 26.

When the device 10 has been tuned to the desired operating condition, wherein the output driver of transistor Q3 of the driver circuit 18 is biased to an ON or semi-ON condition such that no alarm condition is created, the device 10 is considered in "Standby Mode".

If a portion of the metallic infrastructure 26 is damaged, removed or disturbed in such a way that a change of inductance takes place within the infrastructure 26, this change affects both the resonant condition of the infrastructure 26 and also the amplitude of the detected electromagnetic fields present within the infrastructure 26.

These changes will conversely affect both the amplitude and internally generated frequency of the amplification / oscillation circuit 28, thereby changing the output signal feeding into the band pass filter 30 of the filter circuit 14.

Such changes may either increase both amplitude and frequency or decrease the same depending upon the nature of the external changes. This therefore changes the level of signal pass-through from the band pass filter 30 to the driver transistor Q3.

Depending on the nature of the change, either more or less signal may be passed by the band pass filter 30. The driver circuit 18 will either go to a HIGH state or a LOW state depending upon the nature of the change taking place. If the driver circuit 18 goes HIGH, for example due to a sharp increase in amplitude, more signal is permitted to pass through the band pass filter 30 as would be noted by a sudden increase of the intensity of LED 2. The null setting condition of the driver circuit 18 is affected, and one opto relay OR1, OR2 will respond by going to an open circuit condition. If the driver circuit 18 goes LOW due to a sharp decrease in amplitude of the impressed signal, the output frequency from the amplification / oscillation circuit 28 falls out of the spectrum of the band pass filter 30 and a restriction of biasing signal reaching the base of transistor Q3 causes transistor Q3 to either turn off or nearly so and therefore causes the null condition to become interrupted. The other opto relay OR1, OR2 will respond by going to an open circuit condition and a second alarm condition is therefore created. In each case, with an alarm condition activated, the alarm circuit 16 is energised to output an alarm signal. Preferably, the alarm circuit includes a transmitter for outputting the alarm signal to an offsite location.

It should be understood that the opto relays OR1, OR2 may be configured to where a closed state will be generated in alarm condition depending upon the application.

In a typical grounding infrastructure 26 to which this circuit is connected and having one or more metallic conductors 34 to be monitored, typically numerous "ground loops" are present. Ground loops are defined as parallel grounded structures communicating to a single point with metallic conductors 34 interconnecting the structures to form a single ground point where all structures are tied together. Electrically, these structures with interconnecting conductors 34 tend to form parallel inductances forming the overall inductance of the infrastructure 26. When any portion of the overall inductive network formed by the infrastructure 26 is removed, the inductance changes. These changes can either manifest themselves as a change in the resonant frequency or amplitude of impressed RF, electromagnetic fields or both interacting with the grounded network thereby causing the network to change its RC&L characteristics. The change of the RC&L characteristics results in a sympathetic response or change in the resonant state of the device 10, thereby altering the frequency the device 10 is operating at. By careful tuning of the device 10 to a near resonant condition, this sympathetic response or change which is essentially a detuning of the previously tuned signal is readily identified via the band pass filter 30.

Depending on which portion of the grounding infrastructure 26 has been removed or altered, the tuned signal resulting from the previously set resonant condition becomes detuned due to the network imparting a higher state of resonance, considered a full ON state, or the resonant condition becomes detuned due to the network imparting a lower state of resonance, considered an OFF state. In either case, the filter circuit 14 identifies this detuning and an alarm can be generated via the alarm circuit 16 thereby alerting others that such changes have taken place within the monitored infrastructure 26.

Utilising the pick-up coils 52 of the second and third embodiments as inductive pickups allows the device 10 to be wirelessly inductively connected to the grounded infrastructure 26 in order to monitor for a disturbance of any metallic conductor 34 therein.

In this arrangement, the inductive pick-up coil 52 essentially forms part of the amplification / oscillation circuit 28 with the tuning circuit 24 interposed therebetween. The oscillation generated by the amplification / oscillation circuit 28 flows within the pick-up coil 52. When the pick-up coil 52 is incorporated as in the second embodiment illustrated in Figure 6, the pick-up coil 52 is rendered extremely sensitive to both external passive inductances, bodies of capacity, and stray ambient fields such as RF and/or electromagnetic.

In the case of a passive inductance in close proximity to the pick-up coil 52, the passive inductance comes under the influence of the field generated by the amplification / oscillation circuit 28 and the pick-up coil 52 wherein the two inductances tend to form a tuned circuit. If the passive inductance should be disturbed, such as by being moved, a portion of the same being removed, or otherwise being disturbed, the change in the inductive relationship of the two inductances will produce a shift in frequency and amplitude within the amplification / oscillation circuit 28 thereby causing the device 10 to ether fall into a greater or lesser resonant state thereby generating an alarm condition as described previously.

The device 10 is preferably housed in a metallic enclosure and may be conveniently rack mounted if required.

When it is desirable to incorporate an inductive pick-up coil 52, the device 10 can be placed alongside the structure or external circuit to be monitored. In this application, the circuit can be housed either in a non metallic enclosure or a combination non-metallic or metallic enclosure to permit the ease of inductive coupling between the device 10 and the monitored infrastructure 26.

It is also possible where necessary that a housing of the device 10 may be a weather tight enclosure and/or may be buried alongside buried conductors 34 or metallic structures. In this latter case, if the buried conductors 34 are disturbed, such as by sudden removal, the changes of inductance, frequency, amplitude or combination of all three will be sufficient to generate an alarm condition.

In a modified arrangement, if the monitored infrastructure 26 is energized by an electrical current or conveys an RF signal, the electromagnetic field will interact with the oscillation present within the pick-up coil 52 when the two are inductively coupled, as described above. If a significant change occurs, such as the signal being interrupted or the circuit becoming broken in some manner, the resonant condition of the device 10 will become altered thereby generating an alarm condition in the same manner as previously described.

The use of the tickler coil 54 mentioned in relation to the third embodiment and being in close inductive relationship with the pick-up coil 52 is also beneficial in order to increase the sensitivity within the pick-up coil 52. This enables detection of even more subtle changes taking place within the monitored network. When the device 10 has been properly tuned, it is rendered into a highly sensitive state of resonance owing to the additional inductive feedback path afforded by the tickler coil 54. When employed to monitor an external metallic infrastructure 26, even slight changes of the RC&L state of the monitored infrastructure 26 will cause sufficient changes within the circuit to produce the desired alarm condition already alluded to, and such changes may arise from any disturbance including the introduction of a foreign body having a capacity, such as an unauthorised person, into close proximity with the infrastructure 26. As such, the device 10 can be used as a proximity detector.

If the pick-up coil 52 utilises an iron or ferrite core, the device 10 can be rendered sensitive to detect the movement of magnetic fields or metal objects within a distance of several feet from the pick-up coil 52. In this arrangement, it could be employed as a means of detecting the movement of metal structures composed of iron or steel as these metals tend to possess some degree of natural magnetism.

Although the tuning circuit is described as utilising a variable capacitor, any other suitable capacitance adjustment means can be utilised. Additionally or alternatively, it is feasible that a variable inductor could be utilised. In this case, two inductively coupled parallel coils could be or form part of the variable inductor. By moving the coils physically relative to each other, the inductance can be varied. Optionally, if the variable inductor utilises a ferrite core, then an adjustment may be made to the core to vary the inductance.

Other methods of band pass filtering of the output of the amplification / oscillation circuit 28 may be utilised, such as employing a comparator circuit. When the proper adjustments have been made to the B+ and the series variable capacitor C1 communicating with the base of transistor Q1, a frequency of a certain bandwidth is permitted through the band pass filter 30 to drive the third transistor Q3 employed to control the output comprising the alarm circuit 16 of the device 10. Providing this is achievable, then any suitable filter circuit can be utilised.

Furthermore, the band pass filter may be configured in any suitable form. By way of example, resistor R8 could be variable such as in the form of a potentiometer, coil 32 could be a variable core choke, and/or variable capacitor C2 could be a fixed capacitor. At least one of these elements should be variable to enable tuning. However, it could be possible to tune the band pass filter, for example, prior to installation, and then fix the components so that further tuning is not possible or not required.

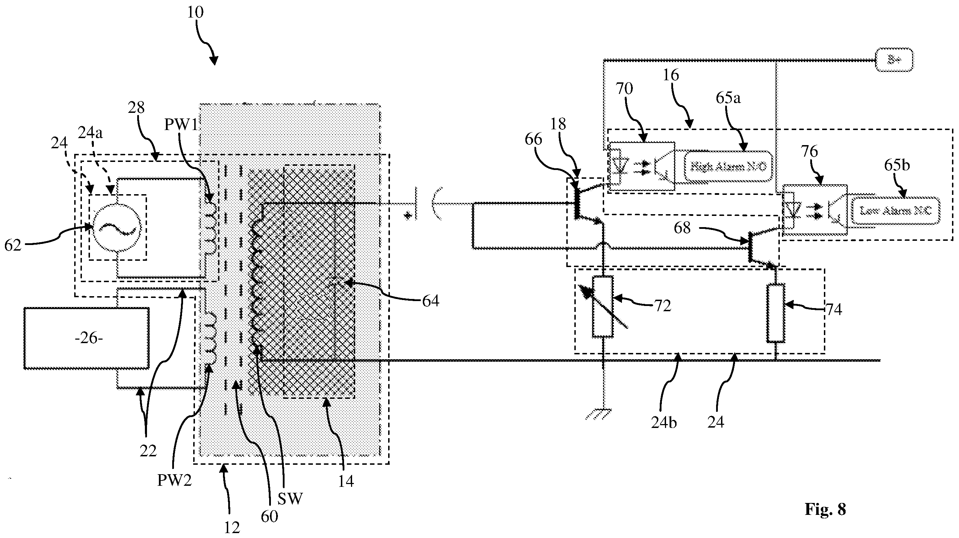

Referring now to Figure 8, a fourth embodiment of the metallic conductor disturbance detection device 10 will now be described. References which are the same as those used in the preceding embodiments refer to similar or identical parts, and therefore further detailed description will be omitted.

The circuit diagram of Figure 8 is simplified for clarity.

The device 10 comprises the sensing circuit 12, filter circuit 14, voltage regulation circuit (not shown), driver circuit 18 and alarm circuit 16, as before.

The sensing circuit 12 and filter circuit 14 may be combined. The filter circuit 14 of this embodiment comprises at least capacitor 64, thereby effectively presenting a wide pass band filter. Additional filter circuitry could be utilised to provide a more preferable narrow pass band filter.

The primary difference in this embodiment resides in the modified sensing circuit 12.

In this embodiment, the sensing circuit 12 has been adapted to include a series wound ferro-resonant transformer 60 with first and second primary windings PW1 and PW2 on the metallic infrastructure side, along with a secondary winding SW on the alarm circuit side.

An oscillating signal, preferably at 34kHz in this particular case, is provided to first primary winding PW1 by an oscillating power source or oscillator 62. This may be sympathetic to the LC circuit or tank circuit comprising secondary winding SW and capacitor 64. Although possibly sympathetic, in the current embodiment, operation may occur at or around half resonant frequency. Other frequencies may also be possible. The oscillating signal is not at the transformer's specific resonant frequency. The oscillating signal has been shown to operate well in a range of 20kHz to 50kHz, and is largely dependent on the specific transformer 60 utilised.

Although preferable, the capacitor 64 can be dispensed with, although this tends to decrease sensitivity.

The oscillating signal in primary winding PW1 induces a voltage at the secondary winding SW. This voltage is proportional to both the input signal at the primary winding PW1 and the inductive influence of the metallic infrastructure 26 mechanically and electrically attached via sense wires 22 to the second primary winding PW2. An electromagnetic field is impressed onto the metallic infrastructure by the oscillator via the first and second primary windings PW1 and PW2.

Any subsequent increase or decrease in the inductance of the metallic infrastructure 26 mechanically and electrically attached to the second primary winding PW2 results in measurable changes to the output voltage and current of the secondary winding SW. This output can be fine tuned by decreasing or increasing the amplitude and/or frequency of the signal being fed from the oscillator 62 into the first primary winding PW1. As such, oscillator 62 effectively forms a first part 24a of a two-part tuning circuit 24.

In a modification, the output can be further fine tuned by the addition of a variable inductor either in series or in parallel with the network sense wires 22, metallic infrastructure 26 and/or the second primary winding PW2.

The amplitude of the signal fed into the first primary winding PW1 is adjusted, so that an output of the secondary winding SW via a connected output amplifier produces just enough voltage and current not to energise the HIGH alarm circuit 65a via driver transistor 66 of driver circuit 18, but to energise the LOW alarm circuit 65b via driver transistor 68 of driver circuit 18 and opto-relay 70. LOW alarm circuit 65b, in this case, is held in a steady state.

A voltage differential between the setting of the HIGH and LOW alarm states is adjusted with variable resistor 72 on the emitter of driver transistor 66. Variable resistor 72 and resistor 74 form a second part 24b of the two-part tuning circuit 24. This enables the changes in signal voltage imparted to the secondary winding SW to be very small allowing triggering of the high or low alarm event.

Although variable resistor 72 is beneficially on the emitter of driver transistor 66, it may be on the base of driver transistor 66, in which case an additional, preferably fixed, resistor would be on the emitter. The variable resistor 72 or a further variable resistor may also be on the emitter of driver transistor 68. The variable resistor 72 may be interchangeable with resistor 74. This interchangeability allows adjustment of the alarm portion 16 for variance in component tolerances of the opto-relay chips or other suitable relay devices 70 and 76.

If both HIGH and LOW alarms are in an energised state, variable resistor 72 can be adjusted by altering its resistance until the HIGH alarm is de-energised. The alarm circuit 16 remains in a steady OK state with the HIGH alarm in a de-energised state and LOW alarm in an energised state. If using an N/C device for the HIGH alarm and an N/O device for the LOW alarm then the alarm conditions themselves can be used as an indicator to fine tune the sensor circuit 12 via the amplitude of the oscillator 62, once the trigger values between HIGH and LOW have been suitably adjusted.

Once at a steady state, any increase in inductance of the metallic infrastructure 26 attached to the second primary winding PW2 caused by disconnection of any or all of the metallic networked parts will cause a discernible rise in voltage at the secondary winding SW. This energises the HIGH alarm circuit 65a via its opt-relay 70 and causes an alarm to activate.

Similarly, any decrease in inductance of the monitored network 26 attached to the second primary winding PW2, caused for example by adding additional metallic infrastructure such as when attempting to defeat the alarm prior to removal of targeted material, will cause a detectable fall in voltage at the secondary winding SW. This de-energises the LOW alarm circuit 65b via its opto-relay 76, causing the alarm to again activate.

Any attempt to circumvent the alarm by removing or tampering with the remote sense wires 22 will result in a detectable increase in inductance which will send the HIGH alarm into an ON state.

Being able to 'lock' the signal frequency of the oscillator 62 is beneficial, since it allows 'one knob' setup and control of the entire circuit via adjustment of the amplitude of oscillator 62 once the variable resistor 72 has been set. However, the amplitude of the signal outputted by the oscillator 62 could be locked instead, wherein the frequency is controlled to tune the inductance sensing circuit 12. Alternatively, the amplitude and the frequency of the oscillating signal outputted by the oscillator 62 may be controllable to tune the inductance sensing circuit 12.

In the above cases, it is preferable to only require a single variable to be controllable during installation, and therefore during production of the detection device 10, the variable resistor 72 and one of the frequency and amplitude of the oscillating signal are set. Any suitable drivers 66 and 68 could be utilised. These may be solid state or mechanical. Multiple opto-relays or solid state relays on a chip may be considered. The ability to detect theft of the metallic infrastructure on site the instant the process is started, enables quick action to make the site safe, bring it back into service and possibly catch the thieves. The alarm circuit of device energises an alarm that can be used for engineer dispatch and/or security personnel. In addition, it is possible that the device could be used to trigger an alternative mechanism or system, such as audible, visual and/or tactile alarm or 'dye bomb'.

Due to the nature of the detection process, circumvention is extremely difficult.

The circuit of the present invention differs greatly from the prior art in the fact that it measures the inductance within the metallic infrastructure and senses changes of inductance taking place within the structure when portions of it are disturbed, such as by removal or tampering.

It is therefore possible to provide a metallic conductor disturbance detection device that is designed to detect inductive changes taking place within grounded or non-grounded metallic conductors. The sensing circuit of the device is connected to an alarm circuit, whereby remote or offsite notification of any disturbance is relayed. The present invention is intended to be used in applications where large bodies of metallic conductors, such as copper cabling and ground conductors, are employed, for example, in telecoms, power generation & distribution, rail transport and other markets that make wide use of large quantities of copper or other valuable metals. It is also possible to utilise the device to monitor for natural degradation or disturbance of metallic conductors due to corrosion or damage inflicted due to accidental conditions, and to provide an alarm to indicate that such conditions have occurred.

The embodiments described above are provided by way of examples only, and various other modifications will be apparent to persons skilled in the field without departing from the scope of the invention as defined by the appended claims.

## Claims

1. A method of detecting disturbance in a metallic conductor (34) of a monitored infrastructure (26), the method comprising the steps of providing an inductance sensing circuit (12) including a transformer (60) having a first primary coil (PW1) and a second primary coil (PW2) on a metallic conductor side, and a secondary coil (SW) on an alarm circuit (16) side, the first primary coil being supplied on a first circuit with an internally generated circuit oscillation by an oscillating power source or oscillator (62), the second primary coil being mechanically and electrically connected to the metallic conductor (34) having a monitorable inductance on a second circuit which is independent of the first circuit such that the oscillating power source or oscillator (62) is not directly connected to the metallic conductor, tuning the inductance sensing circuit (12) based on an electromagnetic field impressed upon the metallic conductor (34) and the internally generated circuit oscillation into the first primary coil, wherein the inductance sensing circuit is tuned as a function of the monitorable inductance on the second circuit, and outputting an alert signal when a tuned output signal from the tuned inductance sensing circuit (12) becomes detuned due to a change in inductance of the metallic conductor (34) by disturbance of at least a portion of the metallic conductor (34).

2. A method as claimed in claim 1, wherein the tuned output signal of the tuned inductance sensing circuit (12) is outputted to a filter circuit (14) filtering based on frequency of the tuned signal.

3. A method as claimed in claim 1 or claim 2, wherein the first primary coil is connected to the oscillator (62).

4. A method as claimed in claim 3, wherein a frequency of a signal outputted by the oscillator (62) is locked, and the inductance sensing circuit (12) is tuneable based on an amplitude of a signal outputted by the oscillator (62); the inductance sensing circuit (12) is tuneable based on an amplitude and frequency of a signal outputted by the oscillator (62); or the inductance sensing circuit (12) is tuneable based on a frequency of a signal outputted by the oscillator (62).

5. A method as claimed in any one of claims 1 to 4, wherein the alert signal is outputted to an alert device which is remote of the inductance sensing circuit (12) installation.

6. A method as claimed in any one of the preceding claims, further comprising the step of providing a tuning circuit (24) for tuning the inductance sensing circuit (12), the tuning circuit (24) providing the internal circuit oscillation which impresses the electromagnetic field on the metallic conductor (34).

7. A method as claimed in any one of the preceding claims, wherein the alarm circuit (16) includes a transmitter for outputting the alarm signal to an offsite location.

8. A metallic conductor disturbance device (10) for a method of detecting disturbance in a metallic conductor (34) of a monitored infrastructure (26), the method comprising the steps of providing an inductance sensing circuit (12) including a transformer (60) having a first primary coil (PW1) and a second primary coil (PW2) on a metallic conductor side, and a secondary coil (SW) on an alarm circuit side, the first primary coil being supplied on a first circuit with an internally generated circuit oscillation by an oscillating power source or oscillator (62), the second primary coil being mechanically and electrically connected to the metallic conductor (34) having a monitorable inductance on a second circuit which is independent of the first circuit such that the oscillating power source or oscillator (62) is not directly connected to the metallic conductor, tuning the inductance sensing circuit (12) based on an electromagnetic field impressed upon the metallic conductor (34) and the internally generated circuit oscillation into the first primary coil, wherein the inductance sensing circuit is tuned as a function of the monitorable inductance on the second circuit, and outputting an alert signal when a tuned output signal from the tuned inductance sensing circuit (12) becomes detuned due to a change in inductance of the metallic conductor (34) by disturbance of at least a portion of the metallic conductor (34).

## Patentansprüche

1. Verfahren zum Erfassen von Störungen in einem metallischen Leiter (34) einer überwachten Infrastruktur (26), wobei das Verfahren die Schritte des Bereitstellens einer Induktivitätsabtastschaltung (12) umfasst, die einen Transformator (60) mit einer ersten Primärspule (PW1) und einer zweiten Primärspule (PW2) auf einer metallischen Leiterseite und einer Sekundärspule (SW) auf einer Alarmschaltungsseite (16) umfasst, wobei die erste Primärspule in einem ersten Stromkreis mit einer integral erzeugten Stromkreisschwingung durch eine oszillierende Stromquelle oder einen Oszillator (62) versorgt wird, wobei die zweite Primärspule mechanisch und elektrisch mit dem metallischen Leiter (34) verbunden ist, der eine überwachbare Induktivität in einem zweiten Stromkreis aufweist, der unabhängig vom ersten Stromkreis ist, so dass die oszillierende Stromquelle oder der Oszillator (62) nicht direkt mit dem metallischen Leiter verbunden ist; Abstimmen der Induktivitätsabtastschaltung (12) basierend auf einem elektromagnetischen Feld, das dem metallischen Leiter (34) aufgeprägt ist, und der integral erzeugten Schaltungsoszillation in die erste Primärspule, wobei die Induktivitätsabtastschaltung als Funktion der überwachbaren Induktivität auf der zweiten Schaltung abgestimmt ist; und Ausgeben eines Alarmsignals, wenn ein abgestimmtes Ausgangssignal der abgestimmten Induktionsdetektionsschaltung (12) aufgrund einer Änderung der Induktivität des metallischen Leiters (34) durch Störung von mindestens einem Abschnitt des metallischen Leiters (34) verstimmt wird.

2. Verfahren wie in Anspruch 1 beansprucht, wobei das abgestimmte Ausgangssignal der abgestimmten Induktivitätsabtastschaltung (12) an eine Filterschaltung (14) ausgegeben wird, die basierend auf der Frequenz des abgestimmten Signals filtert.

3. Verfahren wie in Anspruch 1 oder Anspruch 2 beansprucht, wobei die erste Primärspule mit dem Oszillator (62) verbunden ist.

4. Verfahren wie in Anspruch 3 beansprucht, wobei eine Frequenz eines vom Oszillator (62) ausgegebenen Signals verriegelt ist und die Induktivitätsabtastschaltung (12) basierend auf einer Amplitude eines vom Oszillator (62) ausgegebenen Signals abstimmbar ist; die Induktivitätsabtastschaltung (12) basierend auf einer Amplitude und Frequenz eines vom Oszillator (62) ausgegebenen Signals abstimmbar ist; oder die Induktivitätsabtastschaltung (12) basierend auf einer Frequenz eines vom Oszillator (62) ausgegebenen Signals abstimmbar ist.

5. Verfahren wie in einem der Ansprüche 1 bis 4 beansprucht, wobei das Alarmsignal an eine Alarmvorrichtung ausgegeben wird, die von der Installation der Induktivitätsabtastschaltung (12) entfernt ist.

6. Verfahren, wie in einem der vorhergehenden Ansprüche beansprucht, ferner umfassend den Schritt des Bereitstellens einer Abstimmschaltung (24) zum Abstimmen der Induktivitätsabtastschaltung (12), wobei die Abstimmschaltung (24) die Schwingung der internen Schaltung bereitstellt, die das elektromagnetische Feld auf den metallischen Leiter (34) aufprägt.

7. Verfahren, wie es in einem der vorhergehenden Ansprüche beansprucht wird, wobei die Alarmschaltung (16) einen Sender zum Ausgeben des Alarmsignals an einen externen Standort beinhaltet.

8. Metallische Leiterstörvorrichtung (10) für ein Verfahren zum Erfassen von Störungen in einem metallischen Leiter (34) einer überwachten Infrastruktur (26), wobei das Verfahren die Schritte des Bereitstellens einer Induktivitätsabtastschaltung (12) umfasst, die einen Transformator (60) mit einer ersten Primärspule (PW1) und einer zweiten Primärspule (PW2) auf einer metallischen Leiterseite und einer Sekundärspule (SW) auf einer Alarmschaltungsseite umfasst, wobei die erste Primärspule in einem ersten Stromkreis mit einer integral erzeugten Stromkreisschwingung durch eine oszillierende Stromquelle oder einen Oszillator (62) versorgt wird, wobei die zweite Primärspule mechanisch und elektrisch mit dem metallischen Leiter (34) verbunden ist, der eine überwachbare Induktivität in einem zweiten Stromkreis aufweist, der unabhängig vom ersten Stromkreis ist, so dass die oszillierende Stromquelle oder der Oszillator (62) nicht direkt mit dem metallischen Leiter verbunden ist; Abstimmen der Induktivitätsabtastschaltung (12) basierend auf einem elektromagnetischen Feld, das dem metallischen Leiter (34) aufgeprägt ist, und der integral erzeugten Schaltungsoszillation in die erste Primärspule, wobei die Induktivitätsabtastschaltung als Funktion der überwachbaren Induktivität auf der zweiten Schaltung abgestimmt ist; und Ausgeben eines Alarmsignals, wenn ein abgestimmtes Ausgangssignal der abgestimmten Induktivitätsabtastschaltung (12) aufgrund einer Änderung der Induktivität des metallischen Leiters (34) durch Störung von mindestens einem Abschnitt des metallischen Leiters (34) verstimmt wird.

## Revendications

1. Procédé de détection de perturbations dans un conducteur métallique (34) d'une infrastructure surveillée (26), le procédé comprenant les étapes de fourniture d'un circuit de détection d'inductance (12) comprenant un transformateur (60) ayant une première bobine primaire (PW1) et une seconde bobine primaire (PW2) sur un côté de conducteur métallique, et une bobine secondaire (SW) sur un côté de circuit d'alarme (16), la première bobine primaire étant montée sur un premier circuit présentant une oscillation de circuit produite de manière interne au moyen d'une source de puissance oscillante ou d'un oscillateur (62), la seconde bobine primaire étant reliée de manière mécanique et électrique au conducteur métallique (34) ayant une inductance quantifiable sur un second circuit qui est indépendant du premier circuit de sorte que la source de puissance oscillante ou l'oscillateur (62) ne soit pas directement relié au conducteur métallique, permettant le réglage du circuit de détection d'inductance (12) en fonction d'un champ électromagnétique imprimé sur le conducteur métallique (34) et l'oscillation de circuit produite de manière interne sur la première bobine primaire, le circuit de détection d'inductance étant réglé comme une fonction de l'inductance quantifiable sur le second circuit, et délivrant un signal d'alerte en sortie lorsqu'un signal de sortie réglé à partir du circuit réglé de détection d'inductance (12) devient déréglé du fait d'un changement de l'inductance du conducteur métallique (34) par une perturbation d'au moins une partie du conducteur métallique (34).

2. Procédé selon la revendication 1, dans lequel le signal de sortie réglé du circuit réglé de détection d'inductance (12) est envoyé vers un circuit de filtre (14) permettant la filtration en fonction d'une fréquence du signal réglé.

3. Procédé selon la revendication 1 ou la revendication 2, dans lequel la première bobine primaire est reliée à l'oscillateur (62).

4. Procédé selon la revendication 3, dans lequel une fréquence d'un signal délivré en sortie par l'oscillateur (62) est verrouillée, et le circuit de détection d'inductance (12) est réglable en fonction d'une amplitude d'un signal délivré en sortie par l'oscillateur (62) ; le circuit de détection d'inductance (12) est réglable en fonction d'une amplitude et d'une fréquence d'un signal délivré en sortie par l'oscillateur (62) ; ou le circuit de détection d'inductance (12) est réglable en fonction d'une fréquence d'un signal délivré en sortie par l'oscillateur (62).

5. Procédé selon l'une quelconque des revendications 1 à 4, dans lequel le signal d'alerte est délivré en sortie à un dispositif d'alerte qui est éloigné de l'installation de circuit de détection d'inductance (12).

6. Procédé selon l'une quelconque des revendications précédentes, comprenant en outre l'étape de fourniture d'un circuit de réglage (24) permettant de régler le circuit de détection d'inductance (12), le circuit de réglage (24) fournissant l'oscillation de circuit interne qui imprime le champ électromagnétique sur le conducteur métallique (34).

7. Procédé selon l'une quelconque des revendications précédentes, dans lequel le circuit d'alarme (16) comprend un transmetteur permettant de délivrer en sortie le signal d'alarme à un emplacement hors site.

8. Dispositif de perturbations de conducteur métallique (10) pour un procédé de détection de perturbations dans un conducteur métallique (34) d'une infrastructure surveillée (26), le procédé comprenant les étapes de fourniture d'un circuit de détection d'inductance (12) comprenant un transformateur (60) ayant une première bobine primaire (PW1) et une seconde bobine primaire (PW2) sur un côté de conducteur métallique, et une bobine secondaire (SW) sur un côté de circuit d'alarme, la première bobine primaire étant montée sur un premier circuit présentant une oscillation de circuit produite de manière interne au moyen d'une source de puissance oscillante ou d'un oscillateur (62), la seconde bobine primaire étant reliée de manière mécanique et électrique au conducteur métallique (34) ayant une inductance quantifiable sur un second circuit qui est indépendant du premier circuit de sorte que la source de puissance oscillante ou l'oscillateur (62) ne soit pas directement relié au conducteur métallique, permettant le réglage du circuit de détection d'inductance (12) en fonction d'un champ électromagnétique imprimé sur le conducteur métallique (34) et l'oscillation de circuit produite de manière interne sur la première bobine primaire, le circuit de détection d'inductance étant réglé comme une fonction de l'inductance quantifiable sur le second circuit, et délivrant un signal d'alerte en sortie lorsqu'un signal de sortie réglé à partir du circuit réglé de détection d'inductance (12) devient déréglé du fait d'un changement de l'inductance du conducteur métallique (34) par une perturbation d'au moins une partie du conducteur métallique (34).
